# EUROPÄISCHE PATENTSCHRIFT

(11) **EP 2 305 013 B1**
(45) Veröffentlichungstag und Bekanntmachung des Hinweises auf die Patenterteilung: **15.02.2012**
(21) Anmeldenummer: 09779770.8
(22) Anmeldetag: 16.06.2009
(51) Int. Cl.: H05K 3/28, H05K 1/14, H01L 23/433, H01L 23/495, H05K 3/36

(54) **ELEKTRONISCHE BAUEINHEIT UND VERFAHREN ZU DEREN HERSTELLUNG**
ELECTRONIC ASSEMBLY AND METHOD FOR THE PRODUCTION THEREOF
UNITÉ STRUCTURELLE ÉLECTRONIQUE ET SON PROCÉDÉ DE FABRICATION

(30) Priorität: 17.07.2008 DE 102008040488
(43) Veröffentlichungstag der Anmeldung: 06.04.2011
(73) Patentinhaber: Robert Bosch GmbH, 70442 Stuttgart (DE)
(72) Erfinder: ROETHLINGSHOEFER, Walter, 72766 Reutlingen (DE); GOEBEL, Ulrich, 72760 Reutlingen (DE)
(86) Internationale Anmeldenummer: PCT/EP2009/057409
(87) Internationale Veröffentlichungsnummer: WO 2010/006864

(56) Entgegenhaltungen:
- EP-A- 0 521 335
- EP-A- 0 767 495
- DE-A1-102007 032 142
- US-A- 5 877 937
- US-A1- 2005 161 251
- US-A1- 2005 205 970

## Beschreibung

Die Erfindung betrifft eine elektronische Baueinheit, mit mindestens einem, Bauelemente tragende Leitersubstrat, das mit einem mechanischen Schutz umgeben ist. Die Erfindung betrifft ferner ein hierauf gerichtetes Herstellungsverfahren.

### Stand der Technik

Elektronische Baueinheiten werden zu ihrem Schutz in Gehäuse eingehaust. Insbesondere in der Hybridtechnik werden über aufwendige Montageprozesse bestückte und gebondete Substrate in vorgefertigte Gehäuse eingebaut, wofür in einer typischen Schrittfolge ein Kleben des Substrats auf eine Grundplatte, eine Montage des Gehäuses, ein Bonden des Substrats, ein Vergelen des Substrats und eine Deckelmontage beziehungsweise Gehäusekomplettmontage erfolgen. Daran ist zum Einen der relativ hohe Fertigungsaufwand und die hohe Fertigungstiefe nachteilig, die jeweils mit erheblichen Kosten verbunden sind. Zum Anderen sind die durch die gegebenen Gehäuseformen erreichbaren Abmessungen ungünstig groß.

Die US-Offenlegungsschrift US 2005/0205970 A1 offenbart beispielsweise eine elektronische Baueinheit, mit mindestens einem, Bauelemente tragenden Leitersubstrat, das mit einem mechanischen Schutz umgeben ist. Dabei ist vorgesehen, dass das Leitersubstrat von einer Moldmasse als mechanischen Schutz umgeben ist und mittels mindestens eines eigensteifen, federelastischen, elektrischen Verbindungsleiters kontaktiert ist, wobei der Verbindungsleiter zumindest bereichsweise mit in die Moldmasse eingebettet ist. Durch die Einbettung des Verbindungsleiters (beispielsweise eines Stanzgitters) in die Moldmasse wird dessen positionsgerechte, unverrückbare Anordnung erzielt. Das Leitersubstrat selbst wird von der Moldmasse als mechanischen Schutz umgeben, so dass ein separates Gehäuse vollständig entfällt. Jedoch müssen hierbei die Kontaktstellen vor dem Ummolden miteinander verlötet werden. Eine ähnliche Baueinheit ist auch aus der US-Offenlegungsschrift US 2005/0161251 A1 bekannt.

Aufgabe der Erfindung ist es, eine elektronische Baueinheit bereitzustellen, die auf kleinem Raum eine möglichst hohe Schaltungsdichte in einem schützenden Gehäuse bereitstellt, und die einfach und kostengünstig herstellbar ist. Insbesondere soll hierbei auch eine gute Entwärmung der Schaltungsbauteile erzielt werden.

### Offenbarung der Erfindung

Erfindungsgemäß ist vorgesehen, dass der Verbindungsleiter mit dem Leitersubstrat über eine Niedertemperatur-Sinterverbindung versintert und damit elektrisch sowie mechanisch verbunden ist, wobei das Leitersubstrat und/oder der Verbindungsleiter an ihren jeweiligen Kontaktstellen mit einem bei Niedertemperatur ab etwa 200°C sinternden Metall, insbesondere Silber-Nanopulver und/oder Nickel und/oder Palladium und/oder Gold, beschichtet sind, um beim Ummolden mit der Moldmasse die Niedertemperatur-Sinterverbindung zu bilden. Insbesondere in Hinblick auf Zuverlässigkeit und Einsatz unter extremen Bedingungen ist die Sinterverbindung, die über eine Interdiffusion von Sintermaterialien zustande kommt, für die mechanische Verankerung und elektrische Kontaktierung von Verbindungsleiter und Leitersubstrat besonders vorteilhaft. Während bei weniger anspruchsvollen Anwendungen eine Kontaktierung über eine rein mechanische Federkontaktierung erfolgen kann, wie vorstehend beschrieben, ist für Anwendungen mit häufig wechselnden Temperaturen und mit einer großen Temperaturbandbreite sowie beispielsweise unter mechanischer Beanspruchung (Rütteln oder ähnliches) eine Sinterverbindung zur Erzielung höherer Betriebssicherheit außerordentlich vorteilhaft. Eine Niedertemperatur-Sinterverbindung ist hierbei eine solche, die über ein bei Niedertemperatur sinterndes Metall, beispielsweise Silber-Nanopulver, bewirkt werden kann, das bei Temperaturen in einem Bereich von typischerweise etwa 200°C für eine mechanische Verbindung über Interdiffusion zwischen den zu kontaktierenden Sinterstellen sorgt. Idealerweise werden hierbei die Einlegeteile, also Verbindungsleiter und/oder Leitersubstrat, an ihren jeweiligen Kontaktstellen mit Nickel und/oder Gold beschichtet, um die Interdiffusion von Silber und damit mechanische Verankerung zu fördern. Die Kontaktstellen können wahlweise auch mit Nickel und/oder Palladium und/oder Gold und/oder einer Legierung dieser Metalle beschichtet sein.

In einer weiteren Ausführungsform ist vorgesehen, dass eine Außenseite des Leitersubstrats zumindest bereichsweise aus der Moldmasse zur Wärmeableitung herausragt. Durch das Herausragen der Außenseite aus der Moldmasse ist in sehr einfacher Weise eine Entwärmung der Schaltungsanordnung möglich. Die Wärmeableitung geschieht hierbei über die Luft, die die elektronische Baueinheit im Bereich der herausragenden Außenseite umgibt, und durch das Leitersubstrat hindurch. Spezielle Gehäuse, wie im Stand der Technik zur Wärmeableitung bekannt, können entfallen.

In einer anderen Ausführungsform ist eine Außenseite oder Seite des Leitersubstrats auf einem Grundkörper, insbesondere einer Grundplatte angeordnet, die zumindest bereichsweise aus der Moldmasse zur Wärmeableitung herausragt. Durch die Anordnung auf einer Grundplatte oder einem Grundkörper ist ein großflächiger Wärmeaustrag in/über diesen Grundkörper möglich, insbesondere dann, wenn dieser aus sehr gut wärmeleitendem Material, beispielsweise einem Metall, besteht. Wird dieser aus der Moldmasse herausragend angeordnet, lässt sich eine besonders gute Entwärmung der elektronischen Baueinheit erzielen, ohne dass hierfür ein besonderer Fertigungsaufwand erforderlich wäre.

In einer weiteren Ausführungsform sind mindestens zwei Leitersubstrate mit Abstand zueinander angeordnet, wobei der Verbindungsleiter zwischen den Leitersubstraten angeordnet und mit beiden Leitersubstraten elektrisch verbunden ist. Auf diese Weise lässt sich eine besonders hohe Packungsdichte der elektronischen Baueinheit erreichen, wobei durch die Anordnung des Verbindungsleiters zwischen den Leitersubstraten und die gleichzeitige Kontaktierung beider Leitersubstrate eine sehr einfache, besonders kostengünstige Mehrfachkontaktierung gewährleistet ist. Bevorzugt werden die beiden Leitersubstrate parallel oder in etwa parallel zueinander angeordnet, wobei der Verbindungsleiter in etwa mittig beabstandet zwischen Leitersubstraten angeordnet ist. Trotzdem ist durch diese Anordnung eine sehr gute Entwärmung möglich.

Bevorzugt ragt mindestens ein Abschnitt des Verbindungsleiters aus der Moldmasse als elektrischer Anschluss heraus. Auf diese Weise lässt sich nicht nur eine sehr einfache Mehrfachkontaktierung erzielen, sondern gleichzeitig die Funktion eines Steckverbinders für die elektronische Baueinheit integrieren. Zusätzlicher Komponenten, beispielsweise Messerleisten, bedarf es hierzu nicht.

In einer weiteren Ausführungsform ist das Leitersubstrat eine Leiterplatte. Leiterplatten sind im Stand der Technik hinreichend bekannt. Diese können in besonders einfacher Weise bestückt und in die Baueinheit integriert werden.

In einer weiteren Ausführungsform ist vorgesehen, dass der Verbindungsleiter mit Vorspannung an dem Leitersubstrat anliegt. Der Verbindungsleiter wird zum Zwecke der Kontaktierung mit Vorspannung an das Leitersubstrat angelegt, so dass eine Kontaktierung über die elastische Ausführung des Verbindungsleiters mit dem Leitersubstrat erfolgen kann. Die Vorspannung ergibt sich in sehr einfacher Weise durch die räumliche Anordnung von Leitersubstrat und Verbindungsleiter relativ zueinander.

In einer bevorzugten Ausführungsform ist das Leitersubstrat eine low temperature cofire ceramic (LTCC). Eine low temperature cofire ceramic ist eine solche, bei der das Leitersubstrat in mehreren Schichten aufgebaut ist, die, anders als etwa bei der sogenannte Dickschichttechnik, in einem einzigen Vorgang erzeugt werden können (cofire). Gerade die Einhausung solcher Hybridmodule ist im Stand der Technik mit erheblichem Aufwand und relativ großen Gehäusebauformen verbunden, wobei die Entwärmung nur über aufwendig konstruierte Gehäuse gelingt. Diese Nachteile können mit der erfindungsgemäßen Ausführungsform gelöst werden.

Ferner wird ein Verfahren zur Fertigung einer elektronischen Baueinheit vorgeschlagen, die mindestens ein, Bauelemente tragendes Leitersubstrat aufweist, das mit einem mechanischen Schutz umgeben ist, wobei folgende Schritte ausgeführt werden:
a) Anordnen des Leitersubstrats in einem Moldwerkzeug.
b) Anordnen eines eigensteifen, federelastischen, elektrischen Verbindungsleiters in Gegenüberlage des Leitersubstrats, wobei der Verbindungsleiter zumindest bereichsweise mit dem Leitersubstrat in vorgespannten Berührkontakt tritt.
c) Ummolden der so gewonnenen Anordnung mit Moldmasse zur Ausbildung des mechanischen Schutzes,
wobei erfindungsgemäß vor der vorstehend beschriebenen Verfahrensabfolge auf dem Leitersubstrat Kontaktstellen mittels eines bei Niedertemperatur in einem Temperaturbereich, in dem die Ummoldung erfolgt, sinternden Metalls, insbesondere Silber-Nanopulver und/oder Nickel und/oder Palladium und/oder Gold zum Versintern mit Bereichen des Verbindungsleiters ausgebildet werden, und dass die Versinterung genannter Bereiche während des Umspritzens mit der Moldmasse und/oder während eines Auswärmens der Moldmasse erfolgt.

Das Leitersubstrat wird demzufolge in dem Moldwerkzeug angeordnet, in dem später das Molden erfolgt. Relativ hierzu wird der Verbindungsleiter in Gegenüberlage des Leitersubstrats angeordnet, wobei der Verbindungsleiter in Berührkontakt zum Leitersubstrat tritt, und zwar an den stellen, an denen die Kontaktierung zwischen Verbindungsleiter und Leitersubstrat erfolgen soll. Ist diese Anordnung vorhanden, wird Moldmasse in das Moldwerkzeug eingegeben, um den mechanischen Schutz durch Ummolden der so gewonnenen Anordnung von Leitersubstrat und Verbindungsleiter zur Ausbildung des mechanischen Schutzes. Es wird also nicht in ein vorhandenes Gehäuse eingeschalt, das als separates Bauteil vorliegt. Der mechanische Schutz (im weitesten Sinne also ein neu zu erstellendes Gehäuse) entsteht im Moment des Ummoldens der beschriebenen Anordnung durch die Moldmasse.
Zum Versintern wird kein gesonderter Verfahrensschritt benötigt, es handelt sich hierbei nämlich um ein Niedertemperatursintern, das in einem Temperaturbereich erfolgt, in dem die Ummoldung vorgenommen wird. Die Moldmasse hat beispielsweise eine Temperatur von etwa 300°C, wobei die Versinterung bereits bei Temperaturen um etwa 200°C beginnt.

In einer bevorzugten Verfahrensausbildung wird das Leitersubstrat vor dem Molden mit einem Grundkörper, insbesondere einer wärmeleitfähigen Grundplatte, verbunden oder auf und/oder an dieser angeordnet. Hierdurch lässt sich eine leichte Entwärmung erzielen. In einer besonders bevorzugten Verfahrensausbildung werden zur Erreichung einer hohen Packungsdichte vor dem Ummolden zwei Leitersubstrate jeweils in Gegenüberlage angeordnet, wobei zwischen den beiden Leitersubstraten der Verbindungsleiter zur zumindest abschnittsweisen gleichzeitigen Kontaktierung beider Leitersubstrate angeordnet wird. Selbstverständlich kann der Verbindungsleiter zumindest bereichsweise auch aus der Moldmasse herausragend angeordnet sein, um einen Steckverbinder auszubilden.

Selbstverständlich sind hierbei auch Verfahrensausbildungen möglich, in denen mehr als zwei Leitersubstrate jeweils in Gegenüberlage angeordnet werden, beispielsweise drei, vier oder noch mehr, und wobei zwischen diesen jeweils ein Verbindungsleiter zur zumindest abschnittweisen gleichzeitigen Kontaktierung gegenüberliegender Leitersubstrate angeordnet wird, wobei auch der jeweilige Verbindungsleiter gleichzeitig zu einer Außenkontaktierung aus der Moldmasse herausragend angeordnet werden kann. Im Interesse bestmöglicher Entwärmung werden die Leitersubstrate, die den größten Temperaturaustrag erfordern, jeweils Ober- und Unterseitig eines solchen Stapels angeordnet, damit sie zumindest abschnittsweise aus der Moldmasse herausragen oder mit einer Grundplatte zumindest abschnittsweise aus der Moldmasse herausragend ausgebildet werden können.

In einer weiteren, besonders bevorzugten Verfahrensausbildung wird die Vorspannung des Verbindungsleiters zur Anlage an mindestens einem Leitersubstrat bei einem Schließen des Moldwerkzeugs aufgebracht. Dies bedeutet, dass der Verbindungsleiter lose auf dem mindestens einen Leitersubstrat auf- oder anliegt, und die Vorspannung zur sicheren Kontaktaufbringung zwischen Verbindungsleiter und Leitersubstrat dadurch entsteht, dass das Moldwerkzeug geschlossen und durch das Schließen des Moldwerkzeugs die Relativlage von Verbindungsleiter und Leitersubstrat verändert wird, nämlich im Abstand verkleinert; so entsteht die gewünschte Vorspannung.

Weitere vorteilhafte Ausführungsformen ergeben sich aus den Unteransprüchen und aus Kombinationen derselben; so entsteht die gewünschte Vorspannung.

Die Erfindung wird nachfolgend anhand eines Ausführungsbeispiels näher erläutert, ohne aber hierauf beschränkt zu sein.

### Kurze Beschreibung der Zeichnungen

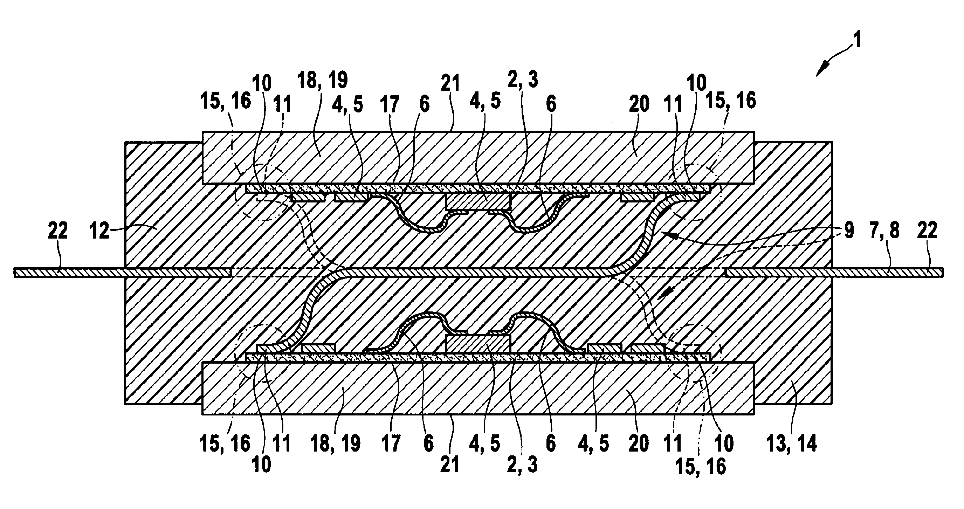

Es zeigt
- die Figur: eine elektronische Baueinheit mit zwei Leitersubstraten und dazwischen angeordneten Verbindungsleiter, der auch als Steckverbinder ausgebildet ist.

### Ausführungsform(en) der Erfindung

Die Figur zeigt eine elektronische Baueinheit 1, mit zwei sich im Wesentlichen parallel gegenüberliegend angeordneten Leitersubstraten 2, nämlich low temperature cofire ceramic (LTCC) 3. Auf diesen sind elektronische Bausteine 4, beispielsweise Halbleiter 5 angeordnet. Diese sind auf dem Leitersubstrat 2 verlötet oder gebondet, beispielsweise über Drahtbonden 6. Die Leitersubstrate 2 sind hierbei dergestalt planparallel mit Abstand zueinander angeordnet, dass zwischen ihnen ein Verbindungsleiter 7, der beispielsweise zumindest abschnittsweise in Form eines Stanzgitters 8 ausgebildet ist, angeordnet ist. Dieser weist zur Kontaktierung der Leitersubstrate 2 federelastische Kontaktfedern 9 auf, die bevorzugt einstückig zu dem Verbindungsleiter 7 ausgebildet sind, beispielsweise durch Stanzen und Formen. Die Kontaktfedern 9 liegen, bedingt durch den Abstand der Leitersubstrate 2 zueinander, mit Vorspannung an Kontaktstellen 10 des jeweiligen Leitersubstrats 2 an. Im Bereich der Kontaktstellen 10 ist auf den Leitersubstraten 2 ein bei Niedertemperatur sinterndes Metall aufgebracht, insbesondere Silber-Nanopulver und/oder Nickel und/oder Palladium und/oder Gold. Bevorzugt ist solches auch an den Enden 11 der Kontaktfedern 9 aufgebracht, die mit den Kontaktstellen 10 in Berührkontakt stehen. Die elektronische Baueinheit 1 wird so ausgebildet, dass die vorbeschriebene Anordnung aus Leitersubstraten 2 und Verbindungsleiter 7 mit einer Moldmasse 12 ummoldet wird, wobei ein mechanischer Schutz 13 für die Leitersubstrate 2 und den eingebetteten Verbindungsleiter 7 in der Art eines durch das Ummolden entstehenden Gehäuses 14 ausgebildet wird. Eines separaten Gehäuses als eigenständigem Bauteil bedarf es hierzu nicht. Durch das Ummolden mit Moldmasse 12 erfolgt ein Temperatureintrag im Bereich der Kontaktfeder 9 und der Kontaktstellen 10, so dass dort das bei Niedertemperatur sinternde Metall Sinterverbindungen 15 ausbildet. Diese sind bevorzugt Niedertemperatursinterverbindungen 16. Hierdurch wird nicht nur eine sehr gute elektrische Kontaktierung zwischen Kontaktfedern 9 und damit mit dem Verbindungsleiter 7 mit den Kontaktstellen 10 bewirkt, sondern auch eine mechanische Fixierung des Verbindungsleiters 7, nämlich über die Kontaktfeder 9 mit den jeweiligen Leitersubstraten 2. Diese Ausführung ist besonders bei mechanischer Beanspruchung wie etwa Rütteln sehr betriebssicher. Die Leitersubstrate 2 liegen mit ihren Rückseiten 17 auf Grundkörpern 18 auf, nämlich Grundplatte 19 aus wärmeleitendem Material 20. Diese ragen über die Moldmasse 12 nach deren Erkalten heraus, und zwar mit der Seite 21, die dem aufgebrachten Leitersubstrat 2 abgewandt ist. Hierdurch lässt sich, ohne dass es zusätzlicher Kühlkörper oder besonders ausgestalteter und für den jeweiligen Anwendungsfall konzipierter, separater Gehäuse bedarf, eine sehr gute Entwärmung der elektronischen Baueinheit 1 erreichen, so dass die Betriebssicherheit in vorteilhafter Weise erhöht ist. Die Herstellung der gezeigten elektronischen Baueinheit 1 ist hierbei über ein Moldwerkzeug (nicht dargestellt) besonders einfach und kostengünstig möglich, insbesondere dann, wenn die erwähnte Vorspannung, mit der der Verbindungsleiter 7 beziehungsweise dessen Kontaktfeder 9 an den Leitersubstraten 2 beziehungsweise deren Kontaktstellen 10 anliegt, während des Moldens beziehungsweise beim Schließen des Moldwerkzeugs erzeugt wird. Weiter kann durch den Verbindungsleiter 7 ein elektrischer Anschluss 22 der elektronischen Baueinheit 1 bewirkt werden, indem der Verbindungsleiter 7 nämlich aus der Moldmasse 12 zumindest bereichsweise herausragend angeordnet wird. Hierdurch lassen sich in sehr vorteilhafter und kostengünstiger Weise zusätzliche Kontaktierungsmittel, beispielsweise Messerleisten, wie sie aus dem Stand der Technik bekannt sind, einsparen. Insbesondere im Bereich der Mikrohybrid-Schaltungstechnik lassen sich so kostengünstig außerordentlich betriebssichere elektronische Baueinheiten herstellen.

## Patentansprüche

1. Elektronische Baueinheit, mit mindestens einem, Bauelemente tragenden Leitersubstrat, das mit einem mechanischen Schutz umgeben ist, wobei das Leitersubstrat (2) von einer Moldmasse (12) als mechanischem Schutz (13) umgeben ist und mittels mindestens eines eigensteifen, federelastischen, elektrischen Verbindungsleiters (7) kontaktiert ist, wobei der Verbindungsleiter (7) zumindest bereichsweise mit in die Moldmasse (12) eingebettet ist, **dadurch gekennzeichnet, dass** der Verbindungsleiter (7) mit dem Leitersubstrat (2) über eine Niedertemperatur-Sinterverbindung (16) versintert ist, wobei das Leitersubstrat (2) und/oder der Verbindungsleiter (7) an ihren jeweiligen Kontaktstellen (10) mit einem bei Niedertemperatur ab etwa 200°C sinternden Metall, insbesondere Silber-Nanopulver und/oder Nickel und/oder Palladium und/oder Gold, beschichtet sind.

2. Baueinheit nach Anspruch 1, **dadurch gekennzeichnet, dass** eine Außenseite des Leitersubstrats (2) zumindest bereichsweise aus der Moldmasse (12) zur Wärmeableitung herausragt.

3. Baueinheit nach einem der vorhergehenden Ansprüche, **dadurch gekennzeichnet, dass** eine Außenseite oder Seite des Leitersubstrats (2) auf einem Grundkörper (18), insbesondere einer Grundplatte (19), angeordnet ist, die zumindest bereichsweise aus der Moldmasse (12) zur Wärmeableitung herausragt.

4. Baueinheit nach einem der vorhergehenden Ansprüche, **gekennzeichnet durch** mindestens zwei Leitersubstrate (2), die mit Abstand zueinander angeordnet sind, wobei der Verbindungsleiter (7) zwischen den Leitersubstraten (2) angeordnet und mit beiden Leitersubstraten (2) elektrisch verbunden ist.

5. Baueinheit nach einem der vorhergehenden Ansprüche, **dadurch gekennzeichnet, dass** mindestens ein Abschnitt des Verbindungsleiters (7) aus der Moldmasse (12) als elektrischer Anschluss herausragt.

6. Baueinheit nach einem der vorhergehenden Ansprüche, **dadurch gekennzeichnet, dass** das Leitersubstrat (2) eine Leiterplatte ist.

7. Baueinheit nach einem der vorhergehenden Ansprüche, **dadurch gekennzeichnet, dass** der Verbindungsleiter (7) mit Vorspannung an dem Leitersubstrat (2) anliegt.

8. Baueinheit nach einem der vorhergehenden Ansprüche, **dadurch gekennzeichnet, dass** das Leitersubstrat (2) eine low temperature cofire ceramic (LTCC) (3) ist.

9. Verfahren zur Fertigung einer elektronischen Baueinheit, die mindestens ein, Bauelemente tragendes Leitersubstrat aufweist, das mit einem mechanischen Schutz umgeben ist, umfassend die Schritte
a) Anordnen des Leitersubstrats in einem Moldwerkzeug
b) Anordnen eines eigensteifen, federelastischen, elektrischen Verbindungs-leiters in Gegenüberlage des Leitersubstrats, wobei der Verbindungsleiter zumindest bereichsweise mit dem Leitersubstrat in vorgespannten Berührkontakt tritt
c) Ummolden der so gewonnenen Anordnung mit Moldmasse zur Ausbildung des mechanischen Schutzes,
**dadurch gekennzeichnet, dass** vor Schritt a) auf dem Leitersubstrat Kontaktstellen mittels eines bei Niedertemperatur in einem Temperaturbereich, in dem die Ummoldung erfolgt, sinternden Metalls, insbesondere Silber-Nanopulver und/oder Nickel und/oder Palladium und/oder Gold zum Versintern mit Bereichen des Verbindungsleiters ausgebildet werden, und dass die Versinterung während des Umspritzens mit Moldmasse und/oder während eines Auswärmens der Moldmasse erfolgt.

10. Verfahren nach Anspruch 9, **dadurch gekennzeichnet, dass** das Leitersubstrat vor dem Molden mit einem Grundkörper, insbesondere einer wärmeleitfähigen Grundplatte, verbunden oder auf und/oder an dieser angeordnet wird.

11. Verfahren nach einem der vorhergehenden Ansprüche, **dadurch gekennzeichnet, dass** vor dem Ummolden zwei Leitersubstrate jeweils in Gegenüberlage angeordnet werden, wobei zwischen den beiden Leitersubstraten der Verbindungsleiter zur zumindest abschnittsweisen gleichzeitigen Kontaktierung beider Leitersubstrate angeordnet wird.

12. Verfahren nach einem der vorhergehenden Ansprüche, **dadurch gekennzeichnet, dass** die Vorspannung des Verbindungsleiters zur Anlage an mindestens einem Leitersubstrat bei einem Schließen des Moldwerkzeugs aufgebracht wird.

## Claims

1. Electronic assembly, comprising at least one conductor substrate which carries components and which is surrounded with a mechanical protection, wherein the conductor substrate (2) is surrounded by a moulding compound (12) as mechanical protection (13) and is contact-connected by means of at least one intrinsically stiff, spring-elastic, electrical connection conductor (7) wherein the connection conductor (7) is concomitantly embedded into the moulding compound (12) at least in regions, **characterized in that** the connection conductor (7) is sintered to the conductor substrate (2) by means of a low temperature sintering connection (16), wherein the conductor substrate (2) and/or the connection conductor (7), at the respective contact locations (10) thereof, are/is coated with a metal that sinters at low temperature starting from approximately 200°C, in particular silver nanopowder and/or nickel and/or palladium and/or gold.

2. Assembly according to Claim 1, **characterized in that** an outer side of the conductor substrate (2) projects at least in regions from the moulding compound (12) for the purpose of heat dissipation.

3. Assembly according to either of the preceding claims, **characterized in that** an outer side or side of the conductor substrate (2) is arranged on a base body (18), in particular a base plate (19), which projects at least in regions from the moulding compound (12) for the purpose of heat dissipation.

4. Assembly according to any of the preceding claims, **characterized by** at least two conductor substrates (2) arranged at a distance from one another, wherein the connection conductor (7) is arranged between the conductor substrates (2) and is electrically connected to both conductor substrates (2).

5. Assembly according to any of the preceding claims, **characterized in that** at least one section of the connection conductor (7) projects from the moulding compound (12) as an electrical terminal.

6. Assembly according to any of the preceding claims, **characterized in that** the conductor substrate (2) is a printed circuit board.

7. Assembly according to any of the preceding claims, **characterized in that** the connection conductor (7) bears against the conductor substrate (2) with prestress.

8. Assembly according to any of the preceding claims, **characterized in that** the conductor substrate (2) is a low temperature cofire ceramic (LTCC)(3).

9. Method for producing an electronic assembly having at least one conductor substrate which carries components and which is surrounded with a mechanical protection, comprising the following steps:
a) arranging the conductor substrate in a mould,
b) arranging an intrinsically stiff spring-elastic, electrical connection conductor in a position opposite the conductor substrate, wherein the connection conductor makes prestressed touching contact with the conductor substrate at least in regions,
c) encapsulating the arrangement thus obtained by moulding with moulding compound in order to form the mechanical protection,
**characterized in that**, before step a), contact locations are formed on the conductor substrate by means of a metal that sinters at low temperature in a temperature range in which the encapsulation by moulding is effected, in particular silver nanopowder and/or nickel and/or palladium and/or gold for sintering with regions of the connection conductor, and **in that** the sintering is effected during the injection-moulding encapsulation with moulding compound and/or during heating of the moulding compound.

10. Method according to Claim 9 **characterized in that** the conductor substrate, prior to moulding, is connected to a base body, in particular a thermally conductive base plate, or is arranged on and/or at the latter.

11. Method according to either of the preceding claims, **characterized in that**, prior to encapsulation by moulding, two conductor substrates are respectively arranged in a position opposite one another, wherein the connection conductor is arranged between the two conductor substrates for the purpose of simultaneously making contact with both conductor substrates at least in sections.

12. Method according to any of the preceding claims, **characterized in that** the prestress of the connection conductor for bearing against at least one conductor substrate is applied when the mould is closed.

## Revendications

1. Composant électronique présentant au moins un substrat conducteur portant des composants et entouré par une protection mécanique, le substrat conducteur (2) étant entouré par une pâte moulée (12) qui sert de protection mécanique (13) et étant mis en contact au moyen d'au moins un conducteur élastique et rigide (7) de raccordement électrique, au moins certaines parties du conducteur de raccordement (7) étant incorporées dans la pâte moulée (12),
**caractérisé en ce que**
le conducteur de raccordement (7) est fritté sur le substrat conducteur (2) par l'intermédiaire d'une liaison frittée (16) réalisée à basse température, le substrat conducteur (2) et/ou le conducteur de raccordement (7) étant revêtus en leurs emplacements de contact (10) respectifs par un métal qui se fritte à basse température, à partir d'environ 200°C, en particulier une nanopoudre d'argent, du nickel, du palladium et/ou de l'or.

2. Module selon la revendication 1, **caractérisé en ce qu'**au moins certaines parties d'un côté extérieur du substrat conducteur (2) débordent au-delà de la pâte moulée (12) pour évacuer la chaleur.

3. Module selon l'une des revendications précédentes, **caractérisé en ce qu'**un côté extérieur ou un côté du substrat conducteur (2) sont disposés sur un corps de base (18) et en particulier une plaque de base (19) dont au moins certaines parties débordent de la pâte moulée (12) pour évacuer la chaleur.

4. Module selon l'une des revendications précédentes, **caractérisé par** au moins deux substrats conducteurs (2) disposés à distance l'un de l'autre, le conducteur de raccordement (7) étant disposé entre les substrats conducteurs (2) et étant raccords électriquement aux deux substrats conducteurs (2).

5. Module selon l'une des revendications précédentes, **caractérisé en ce qu'**au moins une partie du conducteur de raccordement (7) déborde de la pâte moulée (12) pour former une borne de raccordement électrique.

6. Module selon l'une des revendications précédentes, **caractérisé en ce que** le substrat conducteur (2) est une carte de circuit.

7. Module selon l'une des revendications précédentes, **caractérisé en ce que** le conducteur de raccordement (7) est appliqué sur le substrat conducteur (2) avec une précontrainte.

8. Module selon l'une des revendications précédentes, **caractérisé en ce que** le substrat conducteur (2) est une céramique co-cuite à basse température (LTCC - "low temperature cofire ceramic) (3).

9. Procédé de fabrication d'un module électronique qui présente au moins un substrat conducteur portant des composants et entouré par une protection mécanique, le procédé comportant les étapes qui consistent à :
a) placer le substrat conducteur dans un outil de moulage,
b) disposer un conducteur élastique et rigide de raccordement électrique, au moins certaines parties du conducteur de raccordement entrant en contact précontraint avec le substrat conducteur et
c) mouler l'ensemble ainsi obtenu avec une pâte de moulage pour former la protection mécanique, **caractérisé en ce que**
avant l'étape a), des emplacements de contact sont formés sur le substrat conducteur au moyen d'un métal qui se fritte à basse température, dans la plage de température dans laquelle s'effectue le moulage, en particulier une nanopoudre d'argent, du nickel, du palladium et/ou de l'or, pour être fritté avec des parties du conducteur de raccordement, et
**en ce que** le frittage s'effectue pendant l'injection de la pâte de moulage et/ou pendant un chauffage de la pâte de moulage.

10. Procédé selon la revendication 9, **caractérisé en ce qu'**avant le moulage, le substrat conducteur est relié à un corps de base, en particulier à une plaque de base thermiquement conductrice ou est disposé sur cette dernière.

11. Procédé selon l'une des revendications précédentes, **caractérisé en ce qu'**avant le moulage, deux substrats conducteurs sont disposés l'un en face de l'autre, le conducteur de raccordement étant disposé entre les deux substrats conducteurs pour assurer par au moins certaines parties un contact simultané avec les deux substrats conducteurs.

12. Procédé selon l'une des revendications précédentes, **caractérisé en ce que** la précontrainte du conducteur de raccordement pour l'appliquer sur au moins un substrat conducteur est appliquée lors de la fermeture de l'outil de moulage.
